# EUROPEAN PATENT APPLICATION

(11) **EP 3 608 683 A1**
(43) Date of publication of application: **12.02.2020**
(21) Application number: 18187984.2
(22) Date of filing: 08.08.2018
(51) Int. Cl.: G01R 33/30, G01R 33/31

(54) **INSERT DEVICE FOR TRIGGERING PHOTO-INDUCED PROCESSES WITHIN A SAMPLE TO BE ANALYSED BY NMR SPECTROSCOPY**

(71) Applicant: Technische Universität Graz, 8010 Graz (AT)
(72) Inventor: Stadler, Eduard, 8010 Graz (AT); Holly, Christian, 8010 Graz (AT); Gescheidt, Georg, 8020 Graz (AT)
(74) Representative: Patentanwaltskanzlei Matschnig & Forsthuber OG

(57) **Abstract**

The present invention relates to an insert device (1) for triggering photo-induced processes within a sample (2) to be analysed by NMR spectroscopy, said insert device (1) being configured to be inserted into a probe head (3) of a NMR spectroscopy device, wherein the insert device (1) comprises
- a non-magnetic carrying structure (4), for instance made of polymeric or metallic material, said carrying structure (4) including a cavity (4a) for hosting radiofrequency coils and other electronic elements (5) and a sample (2) to be arranged within the centre of the radiofrequency coil (5),
- at least one light source (6a, 6b) arranged within a corresponding opening (4b) of the carrying structure (4), wherein the opening (4b) extends towards the cavity (4a) and wherein the at least one light source (6a, 6b) is configured to emit light into the cavity (4a) in order to trigger photo-induced processes within a sample (2) arranged in the cavity (4a)

## Description

### Field of the invention and description of prior art

The invention relates to an insert device for triggering photo-induced processes within a sample to be analysed by NMR spectroscopy. In order to trigger said photo-induced processes light is irradiated onto the sample.

According to common state of the art, said light stems from light sources that are arranged in manner that does not allow a straight line of sight and high intensity illumination of the sample. Therefore, usually light guides like optical fibres are arranged in close proximity or inserted into the sample guiding the light of external light sources towards the sample.

However, the use of external light sources and light guides does not allow quick adaptions for analysing different samples or different sample properties since the external light sources and guides are commonly elaborately mounted on an NMR device or the sample.

### Summary of the invention

It is therefore an object of the present invention to provide an insert device of the above-mentioned kind, which overcomes the drawbacks of the state of the art.

To achieve this object, an insert device of the initially mentioned kind is, according to the present invention, further developed in that said insert device is configured to be inserted into a probe head of a NMR spectroscopy device, wherein the insert device comprises
- a non-magnetic carrying structure, for instance made of polymeric or metallic material, said carrying structure including a cavity for hosting radiofrequency coils and other electronic elements (for instance gradient coils) and a sample to be arranged within the centre of the radiofrequency coil,
- at least one light source arranged within a corresponding opening of the carrying structure, wherein the opening extends towards the cavity and wherein the at least one light source is configured to emit light into the cavity in order to trigger photo-induced processes within a sample arranged in the cavity.

By virtue of these features an insert device is realized that allows simple and quick analysis of a sample while triggering photo-induced processes within the sample.

Non-magnetic materials have a magnetic susceptibility equal or close to zero. Photo-induced processes can comprise reactions involving excited states, photo-induced isomerizations, molecular rearrangements, photo-induced cleavage of chemical bonds and/ or photo-induced radical processes.

Preferably, the carrying structure and the cavity within the carrying structure both have an essentially cylindrical shape, wherein the longitudinal axes of cylindrical shapes are concentrically arranged. This enhances the homogeneity of the magnetic properties within the cavity.

Preferably, the at least one light source is a high-power led. Such a high-power led can have a nominal power output with at least 20 mW.

Moreover, two, three, four or more light sources can be arranged encircling the cavity. The light sources can be evenly (for instance by having a constant distance between neighbouring light sources) arranged along an inner circumference of the carrying structure, the circumference of the cavity and/ or along the height of the cavity in order to allow an even light distribution within the cavity and hence a sample arranged within the cavity.

In order to enhance heat dissipation of the light source, the opening of the carrying structure for receiving the light source within the carrying structure is of larger size than the corresponding light source in order to allow circulation of a cooling medium around the light source. If the insert device comprises two or more light sources, then the insert device can comprise a corresponding number of receiving openings having similar properties.

Preferably, the carrying structure can comprise a ventilation channel system arranged within the carrying structure for receiving and guiding cooling medium along the carrying structure, said ventilation channel system having at least one inlet for receiving the cooling medium and extending along the carrying structure at least towards each receiving opening for guiding the cooling medium around the light sources into the cavity. The guiding cooling medium can comprise for instance nitrogen that is also used for cooling the NMR sample itself and may be delivered by the NMR console.

Advantageously, the ventilation channel system comprises at least one horizontal ring-shaped channel extending around the cavity within the carrying structure, wherein two or more light sources are arranged within respective receiving openings that are connected to the ring-shaped channel and that are evenly arranged along the ring-shaped channel.

In order to allow easy installation and replacement of the light sources of the insert device, the carrying structure preferably comprises an outer carrying element and an inner carrying element, wherein the inner carrying element is configured to be attached and detached from an inner receiving portion of the outer carrying element, and wherein the inner carrying element comprises the at least one receiving opening and the at least one light source arranged within the respective receiving opening and wherein the outer carrying element comprises the ventilation channel system. Having inner carrying elements equipped with different kinds of light sources allows quick adaptions of the illumination settings of a sample without the need of replacing the entire probe head.

Preferably, the insert further comprises light reflective material arranged on the inside of the carrying structure and surrounding the cavity, wherein the light reflective material comprises at least one opening for receiving at least one light source, wherein the reflective material preferably has a degree of reflectance from above 80%, even more preferably above 90%, for light having a wavelength between 300 and 800 nm.

Advantageously, the carrying structure comprises guide channels for receiving and guiding connecting wires towards each receiving opening in order to connect to the respective light source with connectors at the bottom of the probe head .

Furthermore, the present invention relates to a probe head for receiving and analysing a sample by NMR spectroscopy, comprising an insert device according to the present invention a (radiofrequency) coil arranged within the cavity of the insert device.

Moreover, the present invention also relates to a NMR-system that comprises a control unit, said control unit being connected with the at least one light source in order to control intensity, timing and/ or duration of the light radiation of the at least one light source.

Preferably, the control unit is further configured to receive information with regard to the signals transmitted and received by the coil of the probe head and to control the at least one light source in dependence of this information.

The present invention offers a novel way of illuminating NMR samples inside a spectrometer. It extends the suitability of NMR spectroscopy for studying photochemical reactions in the course of NMR investigations. A custom-made insert is described containing LEDs allowing for an efficient and well-defined irradiation of samples inside NMR probe heads. The achievable optical light power can reach up to more than 300 mW and is spread homogeneously over the NMR sample. An electronic control unit allows to incorporate precise illumination periods into existing NMR pulse programs. Hence, the illumination can be programmed and operated by the spectrometer software. The duration of illumination can reach from short light pulses (few milliseconds) to continuous illumination.

The invention can comprise the following features:
- a hollow, polymeric body housing high power LEDs and an optical reflector that surrounds the detection coil,
- for avoiding undesired heating of the sample and the LEDs, they are cooled by a stream of cold nitrogen, provided by the temperature unit of the spectrometer attached to a tube at the bottom of the probe head. The air is guided through channels in the hollow polymeric body,
- an electronic control unit can drive the LEDs with adjustable currents. It is connected to (triggered by) the spectrometer. The control unit can be easily attached to the probe head via BNC cables. Two separate channels can allow for triggered illumination with sets of different wavelengths.

This setup allows the homogeneous irradiation of the entire NMR sample volume (height = 55 mm) and is hence, highly applicable to follow photo induced chemical reactivity by NMR, e.g. photochemical kinetics as well as chemically induced dynamic nuclear polarization (CIDNP) of radical reactions.

According to common state of the art, devices based on optical fibres that are inserted in the NMR sample tubes have been utilized for the irradiation of NMR samples. Such setups, however suffer from the following drawbacks:
- light intensity is low and illumination inhomogeneous. This makes kinetic experiments error prone and time consuming,
- the tip of the fibres needs to be adjusted in a lengthy process,
- sample handling and preparation is complicated,
- the inserted fibre reduces the detection volume and distorts the homogeneity of the magnetic field.

In contrast to the state of the art, different features and embodiments of the present invention have certain advantages:
- cost effective LEDs can be used instead of lasers,
- direct placement of LEDs inside the probe head avoids tedious and complicated coupling of light sources to optical fibres,
- the inevitable low light intensity in such setups is increased drastically, and
- the design allows easy switching between different irradiation wavelengths.

Moreover,
- the use of air-based cooling system avoids the introduction of any material that negatively affects magnetic field homogeneity, and
- the use of a highly refractive material together with LEDs provides homogeneous light intensity.

### Brief description of the drawings

In the following, in order to further demonstrate the present invention, illustrative and non-restrictive embodiments are discussed, as shown in the drawings, in which
- Fig. 1: shows a schematic view of an insert device according to the present invention,
- Fig. 2: shows a perspective view of an outer carrying element,
- Fig. 3: shows a perspective view of an inner carrying element,
- Fig. 4: shows a schematic view of a probe head according to the invention, and
- Fig. 5: shows a schematic view of an NMR-system according to the invention.

### Detailed description of embodiments of the invention

In the following figures similar reference signs refer to similar features unless expressly depicted otherwise.

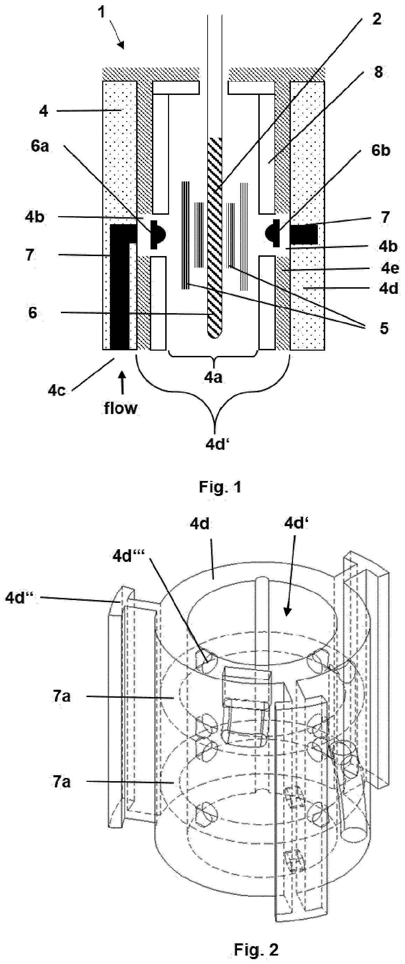

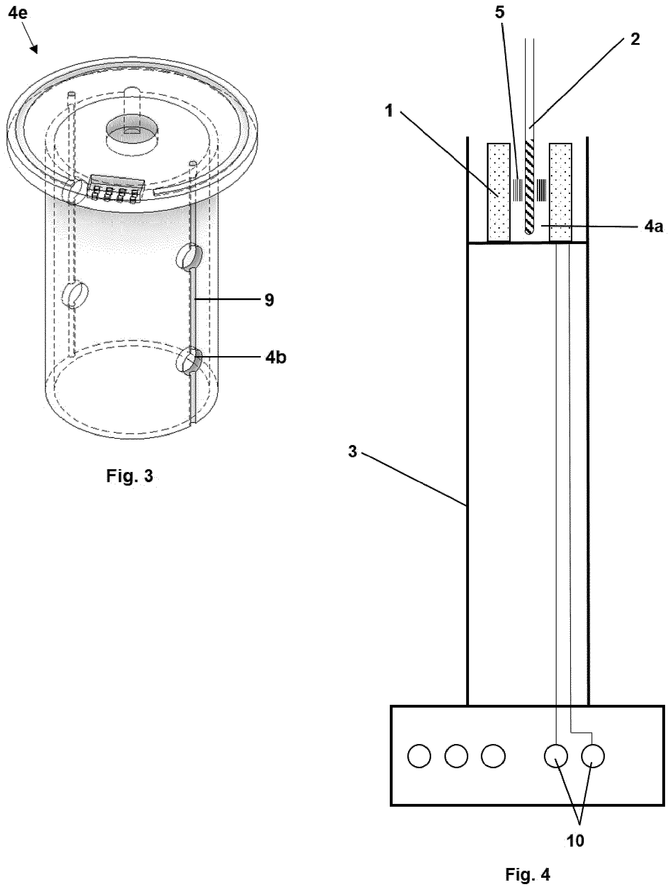

Fig. 1 shows a schematic view of an insert device 1 according to the present invention. The insert device 1 is configured to triggering photo-induced processes within a sample 2, said sample 2 being analysed by NMR spectroscopy. The insert device 1 is configured to be inserted into a probe head 3 (see Fig. 4) of a NMR spectroscopy device.

The insert device 1 comprises a non-magnetic carrying structure 4, for instance made of polymeric or metallic material, said carrying structure 4 including a cavity 4a for hosting radiofrequency coils and other electronic elements 5 and a sample 2 to be arranged within the centre of the radiofrequency coil 5. Moreover, the insert device 1 comprises in the present embodiment a number of light sources 6a and 6b arranged within a corresponding opening 4b of the carrying structure 4, wherein the opening 4b extends towards the cavity 4a and wherein the each light source 6a and 6b is configured to emit light into the cavity 4a in order to trigger photo-induced processes within the sample 2.

The carrying structure 4 and the cavity 4a within the carrying structure 4 both have an essentially cylindrical shape, wherein the longitudinal axes of cylindrical shapes are concentrically arranged. Each light source 6a and 6b is a high-power led.

Each opening 4b of the carrying structure 4 for receiving the light source 6a, 6b within the carrying structure 4 is of larger size than the corresponding light source 6a, 6b in order to allow circulation of a cooling medium around the light source 6a, 6b.

The carrying structure 4 comprises a ventilation channel system 7 arranged within the carrying structure 4 for receiving and guiding cooling medium along the carrying structure 4, said ventilation channel system 7 having at least one inlet 4c for receiving the cooling medium and extending along the carrying structure at least towards each opening 4b of the carrying structure 4 for guiding the cooling medium around the respective light sources 6a, 6b into the cavity 4a.

The insert device 1 further comprises light reflective material 8 arranged on the inside of the carrying structure 4 and surrounding the cavity 4a. The light reflective material 8 comprises corresponding openings for receiving the light source 6a, 6b, wherein the reflective material 8 preferably has a degree of reflectance from above 80%, even more preferably above 90%, for light having a wavelength between 300 and 800 nm.

According to Fig. 2 the carrying structure 4 comprises an outer carrying element 4d and an inner carrying element 4e (see Fig. 3), wherein the inner carrying element 4e is configured to be attached and detached from an inner receiving portion 4d' of the outer carrying element 4d. The outer carrying element 4d comprises protrusions 4d" evenly arranged along the circumference of the carrying element 4d. These protrusions 4d" are designed in order to fix the position of the carrying element within a probe head.

As can be seen in Fig. 3 the inner carrying element 4e comprises in this embodiment eight openings 4b for receiving corresponding eight light sources, which are not shown in this figure. The outer carrying element 4d comprises the ventilation channel system 7 which comprises two horizontal ring-shaped channels 7a extending around the cavity 4a within the carrying structure 4. Openings 4d''' are evenly arranged along the rings in order to connect to the openings 4b, i.e. each opening 4d''' is arranged in an angle of 90° along the longitudinal axis of the carrying structure 4 with regard to the neighbouring opening 4d"'. Same applies on the openings 4b arranged within the inner carrying element 4e.

The inner carrying element 4 comprises guide channels 9 (see Fig. 3) for receiving and guiding connecting wires towards each opening 4b of the carrying structure 4 in order to connect to the respective light source 6a, 6b with connectors 10 at the bottom of the probe head 3 (see Fig. 4).

Fig. 4 shows a schematic view of a probe head 3 according to the invention. The probe head 3 is configured to receive and analyse a sample 2 by NMR spectroscopy and comprises an insert device 1 and a coil 5 arranged within the cavity 4a of the insert device 1.

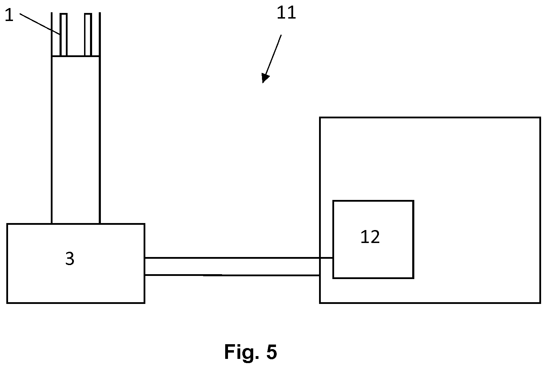

Fig. 5 shows a schematic view of an NMR-system 11 according to the invention. The NMR-system 11 comprises a probe head 3 according to the invention and an electronic control unit 12, said electronic control unit 12 being connected with the at least one light source 6a, 6b in order to control intensity, timing and/ or duration of the light radiation of the at least one light source 6a, 6b.

The electronic control unit 12 is further configured to receive information with regard to the signals transmitted and received by the coil 5 of the probe head 3 and to control the at least one light source 6a, 6b in dependence of this information.

## Claims

1. Insert device (1) for triggering photo-induced processes within a sample (2) to be analysed by NMR spectroscopy, said insert device (1) being configured to be inserted into a probe head (3) of a NMR spectroscopy device, wherein the insert device (1) comprises
- a non-magnetic carrying structure (4), for instance made of polymeric or metallic material, said carrying structure (4) including a cavity (4a) for hosting radiofrequency coils and other electronic elements (5) and a sample (2) to be arranged within the centre of the radiofrequency coil (5),
- at least one light source (6a, 6b) arranged within a corresponding opening (4b) of the carrying structure (4), wherein the opening (4b) extends towards the cavity (4a) and wherein the at least one light source (6a, 6b) is configured to emit light into the cavity (4a) in order to trigger photo-induced processes within a sample (2) arranged in the cavity (4a).

2. Insert device (1) according to claim 1, wherein the carrying structure (4) and the cavity (4a) within the carrying structure (4) both have an essentially cylindrical shape, wherein the longitudinal axes of cylindrical shapes are concentrically arranged.

3. Insert device (1) according to claim 1 or claim 2, wherein the at least one light source (6a, 6b) is a high-power led.

4. Insert device (1) according to any of the preceding claims, wherein the insert device (1) comprises at least two or more light sources (6a, 6b).

5. Insert device (1) according to any of the preceding claims, wherein the light sources (6a, 6b) are evenly arranged along an inner circumference of the carrying structure (4).

6. Insert device (1) according to any of the preceding claims, wherein the opening (4b) of the carrying structure (4) for receiving the light source (6a, 6b) within the carrying structure (4) is of larger size than the corresponding light source (6a, 6b) in order to allow circulation of a cooling medium around the light source (6a, 6b).

7. Insert device (1) according to any of the preceding claims, wherein the carrying structure (4) comprises a ventilation channel system (7) arranged within the carrying structure (4) for receiving and guiding cooling medium along the carrying structure (4), said ventilation channel system (7) having at least one inlet (4c) for receiving the cooling medium and extending along the carrying structure at least towards each opening (4b) of the carrying structure (4) for guiding the cooling medium around the respective light sources (6a, 6b) into the cavity (4a).

8. Insert device (1) according to claim 7, wherein the ventilation channel system (7) comprises at least one horizontal ring-shaped channel () extending around the cavity (4a) within the carrying structure (4), wherein two or more light sources are arranged within respective openings (4b) of the carrying structure (4) that are connected to the ring-shaped channel and that are evenly arranged along the ring-shaped channel.

9. Insert device (1) according to claim 7 or 8, wherein the carrying structure (4) comprises an outer carrying element (4d) and an inner carrying element (4e), wherein the inner carrying element (4e) is configured to be attached and detached from an inner receiving portion (4d') of the outer carrying element (4d), and wherein the inner carrying element (4e) comprises the at least one opening (4b) of the carrying structure (4) and the at least one light source (6a, 6b) arranged within the respective opening (4b) of the carrying structure (4) and wherein the outer carrying element (4d) comprises the ventilation channel system (7).

10. Insert device (1) according to any of the preceding claims, wherein the insert device (1) further comprises light reflective material (8) arranged on the inside of the carrying structure (4) and surrounding the cavity (4a), wherein the light reflective material (8) comprises at least one opening for receiving at least one light source (6a, 6b), wherein the reflective material (8) preferably has a degree of reflectance from above 80%, even more preferably above 90%, for light having a wavelength between 300 and 800 nm.

11. Insert device (1) according to any of the preceding claims, wherein the carrying structure (4) comprises guide channels (9) for receiving and guiding connecting wires towards each opening (4b) of the carrying structure (4) in order to connect to the respective light source (6a, 6b) with connectors (10) at the bottom of the probe head (3).

12. Probe head (3) for receiving and analysing a sample (2) by NMR spectroscopy, comprising an insert device (1) according to any of the preceding claims and a coil (5) arranged within the cavity (4a) of the insert device (1).

13. NMR-system (11) comprising the probe head (3) according to claim 12, wherein the system (11) further comprises an electronic control unit (12), said electronic control unit (12) being connected with the at least one light source (6a, 6b) in order to control intensity, timing and/or duration of the light radiation of the at least one light source (6a, 6b).

14. NMR-system (11) according to claim 13, wherein the electronic control unit (12) is further configured to receive information with regard to the signals transmitted and received by the coil (5) of the probe head (3) and to control the at least one light source (6a, 6b) in dependence of this information.
